# EUROPEAN PATENT APPLICATION

(11) **EP 2 944 385 A1**
(43) Date of publication of application: **18.11.2015**
(21) Application number: 14167960.5
(22) Date of filing: 12.05.2014
(51) Int. Cl.: B08B 7/00, C23C 16/44, H01L 21/02, H01L 21/311, H01L 21/3213

(54) **A process for etching and chamber cleaning and a gas therefor**

(71) Applicant: Solvay SA, 1120 Bruxelles (BE)
(72) Inventor: The designation of the inventor has not yet been filed
(74) Representative: Mross, Stefan P.M.

(57) **Abstract**

The present invention relates to a method for etching and/or removing deposits which is useful for etching and particularly as a chamber cleaning process; and a gas useful therefor. In particular, the present invention also relates to optimized gases and a method for chamber cleaning and/or etching substrates using optimized gases comprising the three components F₂, N₂, and Ar.

## Description

The present invention relates to a method for etching and/or removing deposits which is useful for etching and particularly as a chamber cleaning process; and a gas useful therefor. In particular, the present invention also relates to optimized gases and a method for chamber cleaning and/or etching substrates using optimized gases comprising the three components F₂, N₂, and Ar.

Treatment chambers are used, i.a., in the semiconductor and photovoltaic industry to manufacture semiconductors, flat panel displays or photovoltaic elements. The manufacture generally comprises operations such as etching or chemical vapor deposition of a substrate which, during the treatment, is typically located on a support provided inside the treatment chamber.

During the manufacture of semiconductors, photovoltaic cells, thin film transistor (TFT) liquid crystal displays, and micro-electromechanical systems (MEMS), often consecutive steps of deposition of material, e.g. by chemical vapor deposition (CVD), on a substrate, or consecutive steps of deposition and etching, in a treatment chamber are performed. The substrate, during the treatment, is typically located on a support provided inside the treatment chamber; the treatment processes are often plasma-assisted. Chemical vapor deposition (CVD), physical vapor deposition (PVD) and atomic layer deposition (ALD) processes are widely used to produce semiconductors. By means of such processes, for example, SiO₂layers can be prepared from the so-called TEOS/Ozone CVD process wherein tetraethoxysilane is treated in a plasma apparatus in the presence of ozone or can be deposited by thermal growth. Deposition of W, TiN and TaN are possible using PVD processes. During operation of the respective apparatus, depositions not only occur on the substrates, but also on the inside walls of the reactor chamber. Regular removal of such deposits is desirable to obtain stable and repeatable deposition results with uniform surfaces at acceptable particle levels. The high requirements to sustain stable processes lead to frequent chamber cleaning. NF₃, which emerged as the main cleaning gas.

It was observed that elemental fluorine is a very effective agent both for etching and for cleaning the chambers to remove undesired deposits. Processes of this kind are for example described in WO 2007/116033 (which describes the use of fluorine and certain mixtures as etchant and chamber cleaning agent), WO 2009/080615 (which describes the manufacture of MEMS), 2009/092453 (which describes the manufacture of solar cells), and in WO 2011/051251 which concerns the manufacture of TFTs. EP-A-1138802 discloses that amorphous silicon, also denoted as a-silicon or α-silicon, can be cleaned thermally with fluorine gas, but that silicon oxide or silicon nitride cannot be removed by this method. Carbonyl fluoride (COF₂) can also be applied as etchant and chamber cleaning agent.

Often, the steps of etching or chamber cleaning are assisted by plasma. Plasma can be generated by applying a high frequency voltage between opposed electrodes or in a magnetron which provides microwaves the frequency of which is to the upper range of radio frequencies. The electromagnetic waves heat up the gas phase inside the plasma reactor. Atoms with high reactivity are formed, e.g. F atoms which then etch matter away, forming volatile reaction products. Amorphous, crystalline or microcrystalline silicon, for example, forms volatile SiF₄ which can be removed from the plasma reactor. Undesired deposits on the inner walls of the reactor, e.g. deposits of silicon, silicon nitride can likewise be transformed into volatile reaction products. In these prior art etching and/or chamber cleaning processes the plasma is formed directly, e.g. in-situ, in the reactor or cleaning chamber.

US patent application publication 2003/0056388 discloses a cleaning gas for chamber cleaning which comprises SF₆ and F₂ and/or NF₃. US patent 5425842 discloses a process for chamber cleaning using F₂ or a fluorine compound and oxygen or an oxygen compound. With such gas mixtures, polymeric fluorocarbon contaminations can be removed. In a similar way, such contaminations on the surface of semiconductors can be removed. The contaminations are often formed when semiconductors are etched in a plasma chamber using fluorocarbons or hydrofluorocarbons as etching gas, such as CF₄, C₂F₆ and CHF₃, sometimes mixed with hydrogen.

NF₃ is often used as etching gas in the production of semiconductors. It can be used to etch inorganic coatings like SiON, amorphous Si, SiO₂, TiN, TaN or W (tungsten).

The object of the present invention is to identify a gas composition which is effective as chamber cleaning gas, as etching gas and for other purposes, especially in the field of semiconductor production, with a significantly reduced environmentally destructive global warming emission. A special problem of the present invention is to identify an etching gas composition useful for etching inorganic materials, in the form of mixtures, which can be used especially for etching inorganic contaminations in the frame of chamber cleaning. Fluorine gas has no global warming potential and may be used with relatively low energy consumption compared for example to conventionally used NF₃ cleaning gas, while efficiently removing undesired deposits.

These and other objects of the present invention are achieved by the process according to the claims.

In a first aspect, the present invention now makes available in particular an efficient etching and/or chamber cleaning process which does not require the formation of the plasma directly or in-situ in the reactor and/or cleaning chamber, as well as an optimized ternary gas mixture therefor comprising or consisting of F₂, N₂, and Ar. Thus, the invention allows for a plasma source separate, e.g. remote from the reactor and/or cleaning chamber ("remote plasma source", "RPS") in general, and in particular if using the optimized gas mixture of the present invention comprising or consisting of F₂, N₂, and Ar in a composition as defined in the claims and further described herein after.

In a second aspect, the present invention now makes available in particular an optimized gas mixture comprising or consisting of F₂, N₂, and Ar in a composition as defined in the claims and further described herein after.

The gas compositions of the present invention represent an even more effective etching gas mixture comprising or consisting of F₂, N₂, and Ar when compared to the known NF₃ etching and/or cleaning gas, but surprisingly also when compared to the known F₂ / N₂, / Ar compositions which are used in the prior art for the formation of a plasma directly or in-situ in the reactor and/or cleaning chamber. In the gas mixtures of the invention the Ar content is increased and the fluorine content is decreased, when compared to the known prior art compositions, with a lower Ar content and higher fluorine content, which are used for the formation of a plasma directly or in-situ in the reactor and/or cleaning chamber. Although compared to said prior art gas mixtures, the fluorine content is diluted in the compositions of the present invention, surprisingly the compositions of the invention are found more efficient and thus superior in etching and/or chamber cleaning processes, and in particular, they do not require the formation of the plasma directly or in-situ in the reactor and/or cleaning chamber. Thus, the invention allows for the use of a plasma source separate, e.g. remote from the reactor and/or cleaning chamber ("remote plasma source", "RPS"). Surprisingly, molecular fluorine in these gas mixtures of the invention, comprising or consisting of F₂, N₂, and Ar in specifically defined concentration ranges or ratios, respectively, is particularly efficient for removal of deposits thus allowing for good cleaning efficiency and reduced cleaning time, even though the plasma is formed remote from the reactor used for etching and/or the chamber cleaning.

Some gas mixtures for use in etching and/or chamber cleaning comprising or consisting of F₂, N₂, and Ar are already known in the prior art, for example, from WO 2007/116033 or WO 2009/080615, as both mentioned above. However, the gas mixture of the present invention comprising or consisting of F₂, N₂, and Ar distinguish over the mixtures described in the WO 2007/116033 by its specifically selected composition and especially by the dedicated optimized range of Ar in the mixture or the ratio of Ar to especially fluorine. Thereby, the gas mixture of the present invention comprising or consisting of F₂, N₂, and Ar is surprisingly also enabling etching and/or chamber cleaning processes with a remote plasma source (RPS) instead of requiring in-situ plasma generation in the etching and/or chamber cleaning chamber. Furthermore, the gas mixture of the present invention comprising or consisting of F₂, N₂, and Ar is surprisingly optimized in that the show enhanced etching and/or cleaning efficiency, even though the concentration of F₂ in the gas mixtures of the present invention is lower than in the prior art mixtures. The gas mixture of the present invention comprising or consisting of F₂, N₂, and Ar is surprisingly better also than the NF₃ in the prior art.

### Brief description of the Figures :

- Fig. 1 :: Comparison of F₂ / Ar / N₂ gas mixtures with NF₃ in a cleaning process; effects of the variation of the addition of Ar at constant temperature of 400°C and at constant pressure of 3.5 Torr. Particularly this Figure shows a very surprising and beneficial effect of the invention.
- Fig. 2 :: Comparison of F₂ / Ar / N₂ gas mixtures with NF₃ in a cleaning process; effects of the variation of the pressure at constant temperature of 400°C.
- Fig. 3 :: Comparison of F₂ / Ar / N₂ gas mixtures with NF₃ in a cleaning process; effects of the variation of the process temperature at constant pressure of 3.5 Torr.

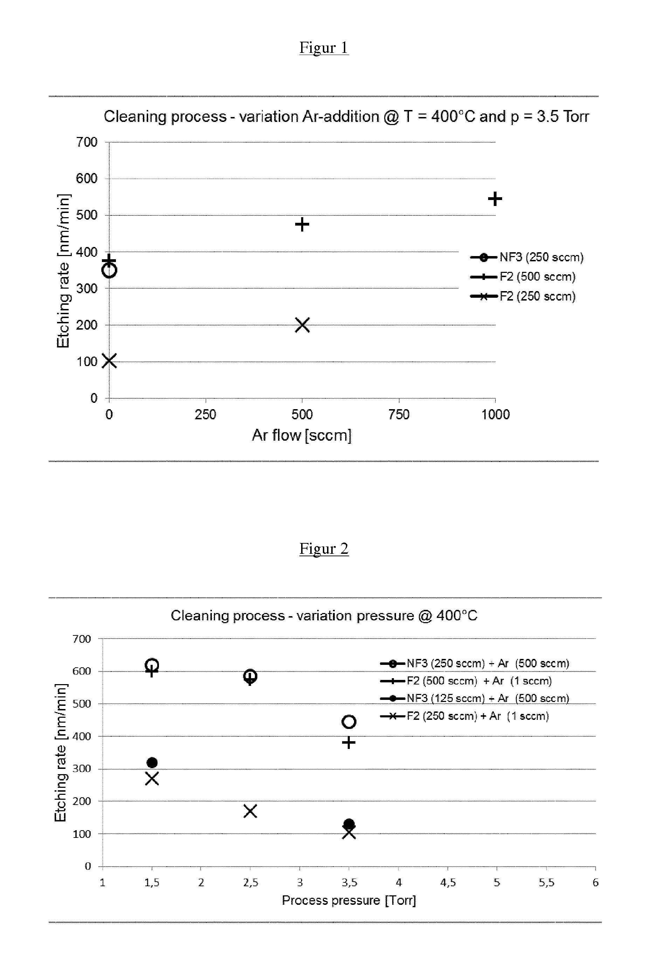

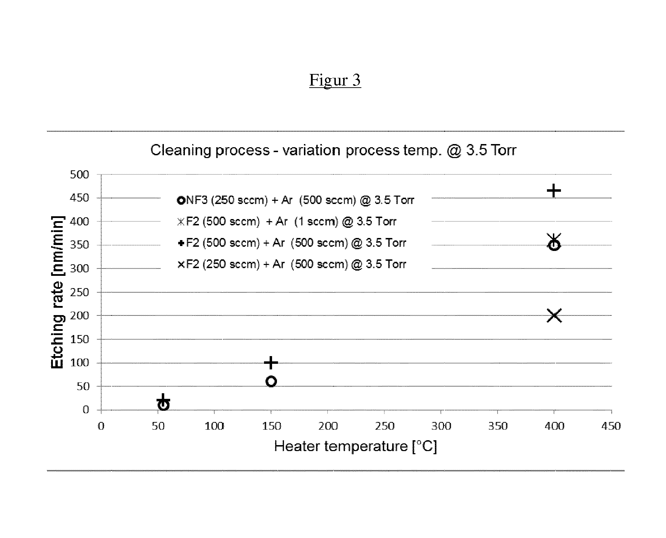

The Figures are based on the experiments further described in detail in the examples below. From the comparison of the F₂ / Ar / N₂ gas mixtures with NF₃ gas in a cleaning process as displayed in the Fig. 1 to 3 it can be concluded that a adding additional Ar to the cleaning gas F₂ / Ar / N₂ results in higher SiO₂ etch rates compared to the initial F₂ / Ar / N₂ mixture and compared to NF₃. The initial F₂ / Ar / N₂ mixture is understood as the known prior art composition of 20 % v/v F₂, 10 % v/v Ar, and 70 % v/v N₂. The observed effect is true for 10 s and for 60 s etching time, and thus can be considered to be not limited to only a first ignition effect. While not intended to be bound by theory, according to the inventors guess a possible reason is that the addition of additional Ar to the initial gas or gas mixture increases the live time of the F₂ radicals and slows down recombination process of previously generated fluorine radicals.

The results displayed in the Figures are showing that the F₂ / Ar / N₂ plus additionally added Ar has an etching rate of 470 nm/min, compared to an etching rate of 348 nm/min found for NF₃. This reflects an etching rate which is more than 100 nm/min faster in case of F₂ / Ar / N₂ than in case of NF₃ which corresponds to about 25 to 30 % faster cleaning. Based on a NF₃ cleaning time of 60 s, it can be computed that according to the invention the etching and/or cleaning time can be reduced to 45 s. This etching and/or cleaning time savings might be converted into an increase of machinery throughput of about 15 %. Based on a monthly production of 80.000 wafers per month, the present invention, for example, estimates an increase of productivity in the range of about additionally producible 12.000 wafers per month.

Particularly, in the first aspect, the invention relates to a process for etching or cleaning the surface of semiconductor material, solar panels or flat panels (TFTs and LCDs), or cleaning chambers of apparatus used for semiconductor manufacturing, characterized in that a mixture comprising or consisting of fluorine and argon, and one or more inert gases selected from the group consisting of nitrogen and noble gases other than argon is used, wherein the argon content is in the range of from greater than 10 % (v/v) to less than 70 % (v/v), preferably to less than 60 % (v/v), more preferably to less than 55 % (v/v), and most preferably to less than 50 % (v/v), relative to the total composition of fluorine and argon and the inert gases, preferably N₂ (nitrogen) as the inert gas, as 100 % (v/v). Preferably, the argon content is in the range of from greater than 11 % (v/v), 12 % (v/v), 13 % (v/v), 14 % (v/v), 15 % (v/v), 16 % (v/v), 17 % (v/v), 18 % (v/v), 19 % (v/v), 20 % (v/v), 21 % (v/v), 22 % (v/v), 23 % (v/v), 24 % (v/v), or 25 % (v/v), in each case to less than 70 % (v/v), preferably to less than 60 % (v/v), more preferably to less than 55 % (v/v), and most preferably to less than 50 % (v/v); all relative to the total composition of fluorine and argon and the inert gases, preferably N₂ (nitrogen) as the inert gas, as 100 % (v/v).

Alternatively to defining in the concentration and/or the amount of the constituents in the compositions of F₂ / Ar / N₂ gas mixtures by % volume/volume (v/v) for practical reason, e.g. for performing variable experiments as described herein, it may be useful to calculate the concentration and/or the amount of the gas constituents or gas mixtures by the gas flow in terms of "standard cubic centimeter" (sccm). Thus, Table A shows a conversion table for correlating the % (v/v) values of the constituents of the mixtures according to the invention (B1 to B4) and of the initially used prior art gas mixture (A1) to the "standard cubic centimeter" (sccm) values. For example, the process of the invention is performed such that the etching and/or cleaning gas is introduced into the etching and/or cleaning chamber, e.g. a CVD chamber, such that the F₂ gas flow, as the etching and/or cleaning gas component of the gas mixuture, measured as "standard cubic centimeter" (sccm) is in a range of from 200 to 1000 sccm.

**Table A: Exemplary compositions of gas mixtures of the present invention (B1 to B4, and the initial gas mixture (A1) of the prior art. The term "gas" in the table means the initial F₂ / Ar / N₂ mixture known prior art composition of 20 % v/v F₂, 10 % v/v Ar, and 70 % v/v N₂. Corresponding to 2500 sccm total gas flow ("total sccm").**

| No. | sccm gas, and +Ar, | F₂ % v/v | Ar % v/v | N₂ % v/v | total sccm | F₂ sccm | Ar sccm | N₂ sccm |
|---|---|---|---|---|---|---|---|---|
| A1 | 2500 | 20 | 10 | 70 | 2500 | 500 | 250 | 1750 |
| B1 | +500 | 16.67 | 25 | 58.33 | 3000 | 500 | 750 | 1750 |
| B2 | +1000 | 14.29 | 35.71 | 50.0 | 3500 | 500 | 1250 | 1750 |
| B3 | +1500 | 12.5 | 43.75 | 43.75 | 4000 | 500 | 1750 | 1750 |
| B4 | +1750 | 11.765 | 47.06 | 41.175 | 4250 | 500 | 2000 | 1750 |

In preferred embodiments of the process of the invention the argon content is in the range of from equal to or greater than 15 % (v/v), preferably of from equal to or greater than 20 % (v/v), more preferably of from equal to or greater than 25 % (v/v), and even more preferably of from equal to or greater than 30 % (v/v), in each case to equal to or less than 60 % (v/v), relative to the total composition of fluorine and argon and the inert gases as 100 % (v/v). In more preferred variants of this embodiment of the invention, the argon content is in the range of from greater than 15 % (v/v), 20 % (v/v), 25 % (v/v), 30 % (v/v), in each case to less than 55 % (v/v), preferably to less than 50 % (v/v), more preferably to less than 45 % (v/v), and most preferably to less than 40 % (v/v); all relative to the total composition of fluorine and argon and the inert gases, preferably N₂ (nitrogen) as the inert gas, as 100 % (v/v).

In preferred embodiments of the process of the invention the fluorine content lies in the range of from equal to or greater than 1 % (v/v) to equal to or less than 30 % (v/v), the inert gases selected from the group consisting of nitrogen and noble gases other than argon being the balance to 100 vol.-%. Thus, fluorine content can be any value in the said range, e.g. the fluorine content can be in the range of from equal to or greater than 1 % (v/v), 2 % (v/v), 3 % (v/v), 4 % (v/v), 5 % (v/v), 6 % (v/v), 7 % (v/v), 8 % (v/v), 9 % (v/v), 10 % (v/v), 11 % (v/v), 12 % (v/v), 13 % (v/v), 14 % (v/v), 15 % (v/v), 16 % (v/v), 17 % (v/v), 18 % (v/v), 19 % (v/v), 20 % (v/v), 21 % (v/v), 22 % (v/v), 23 % (v/v), 24 % (v/v), 25 % (v/v), 26 % (v/v), 27 % (v/v), 28 % (v/v), 29 % (v/v), and in each case to equal to or less than 30 % (v/v), the inert gases selected from the group consisting of nitrogen and noble gases other than argon being the balance to 100 vol.-%. Or, fluorine content can be any value in the said range, e.g. the fluorine content can be in the range of from equal to or greater than 1 %, or any of the before given lower % (v/v) values, to equal to or less than 30 % (v/v), 29 % (v/v), 28 % (v/v), 27 % (v/v), 26 % (v/v), 25 % (v/v), 24 % (v/v), 23 % (v/v), 22 % (v/v), 21 % (v/v), 20 % (v/v), 19 % (v/v), 18 % (v/v), 17 % (v/v), 16 % (v/v), 15 % (v/v), 14 % (v/v), 13 % (v/v), 12 % (v/v), 11 % (v/v), 10 % (v/v), 9 % (v/v), 8 % (v/v), 7 % (v/v), 6 % (v/v), 5 % (v/v), 4 % (v/v), 3 % (v/v), 2 % (v/v).

In more preferred embodiments of the process of the invention the fluorine content lies in the range of from equal to or greater than 8 % (v/v) to less than 20 % (v/v), more preferably in the range of from equal to or greater than 9 % (v/v) to equal to or less than 12 % (v/v), even more preferably in the range of from equal to or greater than 10.5 % (v/v) to equal to or less than 12.0 % (v/v), the inert gases selected from the group consisting of nitrogen and noble gases other than argon being the balance to 100 vol.-%.

The present invention also relates to a gas mixture comprising or consisting of fluorine and argon, and one or more inert gases selected from the group consisting of nitrogen and noble gases other than argon is used, wherein the argon content is in the range of from greater than 10 % (v/v) to less than 70 % (v/v), preferably to less than 60 % (v/v), more preferably to less than 55 % (v/v), and most preferably to less than 50 % (v/v), relative to the total composition of fluorine and argon and the inert gases, preferably N₂ (nitrogen) as the inert gas, as 100 % (v/v). Especially, the invention also relates to a mixture comprising or consisting of a mixture comprising or consisting of fluorine and argon, and one or more inert gases selected from the group consisting of nitrogen and noble gases other than argon, and as these mixtures are defined above in terms of their composition in the context of the process according to the invention. For example, in the gas mixture comprising or consisting of fluorine and argon, and one or more inert gases selected from the group consisting of nitrogen and noble gases other than argon, the argon content especially can be in the range of from greater than 10 % (v/v) to less than 50 % (v/v), relative to the composition of fluorine and argon and the inert gases as 100 % (v/v). In a preferred embodiment, the gas mixture comprises or consists of 10-20 % (v/v) fluorine, 40-50 % (v/v) argon and 40-50 % (v/v) nitrogen, more preferably, 10-15 % (v/v) fluorine, 40-50 % (v/v) argon and 40-50 % (v/v) nitrogen, specifically 13 % (v/v) fluorine, 45 % (v/v) argon and 42 % (v/v) nitrogen. The best results with 13% (v/v) F₂ mixture was achieved at an application pressure of 1 to 8 Torr, preferably 1 to 5 Torr. Further examples for the composition of the gas mixture according to the invention, consisting of fluorine and argon and nitrogen, preferably are defined in any one of the values and/or ranges given above in the context of the process of the invention.

In a another embodiment the present invention also pertains to the use of a mixture comprising or consisting of a mixture comprising or consisting of fluorine and argon, and one or more inert gases selected from the group consisting of nitrogen and noble gases other than argon, and as these mixtures are defined above in terms of their composition in the context of the process according to the invention, as drop-in component of gas mixtures applied in plasma apparatus, preferably in remote plasma source apparatus, and more preferably in remote plasma source apparatus for etching and/or chamber chambers or apparatus, and most preferably in remote plasma source apparatus for etching and/or cleaning chambers or apparatus. Thus, the gas mixtures in the plasma apparatus can have any one of the values and/or ranges as given in relation to the process of the present invention.

In a further embodiment the present invention also pertains to a plasma apparatus for etching semiconductors, solar panels and flat panels (TFTs and LCDs), and/or chamber cleaning tuned for use of NF₃ and/or F₂ etching gas component, characterized by a content of a mixture comprising or consisting of a mixture comprising or consisting of fluorine and argon, and one or more inert gases selected from the group consisting of nitrogen and noble gases other than argon, and as these mixtures are defined above in terms of their composition in the context of the process according to the invention. Thus, the gas mixtures in the plasma apparatus can have any one of the values and/or ranges as given in relation to the process of the present invention.

In the following the process of the invention shall be further described in more detail. The skilled person will be aware that the process detail relate to the particular gas mixtures of the present invention and the use thereof. Accordingly, the following details given for the process of the invention are representative for and also equally apply to the gas mixtures of the present invention and the use thereof.

Particularly, the process according to the invention is plasma assisted and the plasma is generated in a plasma source remote from the etching and/or cleaning chambers or apparatus. Especially, the process is a chamber cleaning process. In a preferred embodiment of the invention, therefore, the process of the invention is plasma enhanced, preferably enhanced by a remote plasma (e.g. a remote plasma source).

The skilled person is generally familiar with the selection of the pressure to be applied in the process of the present invention. In the process of the invention the pressure is suitably in the range between 1 and 200 Pa, preferably 10 and 100 Pa, especially preferred in the range between 10 and 50 Pa.

In a particular embodiment of the process according to the invention, the process is characterized in that the pressure is equal to or lower than 5 Torr. In an example, the process of the invention is performed at a pressure of about 3.5 Torr.

The skilled person is generally familiar with the selection of the temperature to be applied in the process of the present invention. In the process of the invention that is plasma-supported the temperature lies in the range between 100 and 600°C, preferably between 150 and 450°C. In an embodiment of the process of the invention the temperature is equal to or higher than 200°C; but e.g. lower than 600°C, preferably lower than 450°C. In an example, the process of the invention is performed at a temperature of about 400°C.

In a particular embodiment of the process according to the invention, the process is characterized in that the inorganic material is amorphous Si, Si₃N₄, SiOₓN_{y} wherein 0 < x ≤ 3 and 0 ≤ y ≤ 4, SiO₂, TaN, TiN or W, preferably SiO₂ and/or Si₃N₄.

In a particular embodiment of the process according to the invention, the process is characterized in that organic material is removed from the surface of semiconductors, solar panels or flat panels (TFTs and LCDs), or that chambers contaminated with organic material are cleaned.

In a another embodiment of the process according to the invention, the process is characterized in that a mixture comprising or consisting of F₂, Ar and N₂ is introduced into the etching and/or cleaning chamber, for example into a CVD chamber. In an alternative embodiment of the process according to the invention, the process is characterized in that separately but simultaneously, Ar and a gas mixture comprising or consisting of F₂ and N₂ are introduced into the etching and/or cleaning chamber, for example into a CVD chamber.

In a particular embodiment of the process according to the invention, the process is characterized in that the organic material is a fluorinated polymer originating from etching semiconductors, solar panels or flat panels (TFTs and LCDs) with fluorinated carbon compounds, optionally in the presence of hydrogen, as etching gas.

In a particular embodiment of the process according to the invention, the process is characterized in that oxygen is additionally present during removal of organic material. Thus, the invention is also directed to a wherein polysilicon is removed and wherein the cleaning gas further contains oxygen, N₂O or a mixture of both.

Generally, in the process of the invention the deposits are selected from the group consisting of phosphosilicate glass (PSG), boron-doped phosphosilicate glass (BPSG), and optionally doped silicon oxides, obtained by decomposition of silanes in the presence of oxygen or by decomposition of tetraethoxysilane. Especially, in the process of the invention the deposits are selected from the group consisting of optionally doped silicon oxides, obtained by thermal decomposition of tetraethoxysilicate, plasma-enhanced decomposition of tetraethoxysilicate (PETEOS), high-density plasma enhanced decomposition of tetraethoxysilicate (HDPTEOS), or from low pressure decomposed tetraethoxysilicate (LPTEOS).

The process according to the present invention provides for the etching of semiconductor material (e.g. Reactive Ion Etching, in short: RIE), for surface cleaning and surface preparation of semiconductors, solar panels and flat panels (Thin Film Transistors, Liquid Crystal Displays, short: TFT/LCD application) and for cleaning of chambers for semiconductor production (TFT/LCD application) and is characterized by the application of a mixture of fluorine and argon, and one or more inert gases selected from the group consisting of nitrogen and the noble gases other than argon (He, Xe and Kr) as defined above.

In general, the fluorine content lies in the range of from equal to or greater than 1 % (v/v) to equal to or less than 30 % (v/v), e.g. between 5 - 25 % (v/v), preferably in the range of from equal to or greater than 8 % (v/v) to less than 20 % (v/v), e.g. between 8 - 15 % (v/v), further preferred in the range of from equal to or greater than 9 % (v/v) to less than 13 % (v/v), more preferably in the range of from equal to or greater than 9 % (v/v) to equal to or less than 12 % (v/v), even more preferably in the range of from equal to or greater than 10.5 % (v/v) to equal to or less than 12.0 % (v/v), the inert gases selected from the group consisting of nitrogen and noble gases other than argon being the balance to 100 vol.-%. The mixture can be formed in the reactor, or, which is preferred, a mixture of fluorine and the inert gas or gases is formed before introducing it into the reactor. If the gases are introduced in such a premixed form into the reactor, a homogenous mixture is provided throughout the reactor chamber.

According to a preferred embodiment of the invention, the gas mixture consists of fluorine and argon, and the inert gas or inert gases (other than argon), the fluorine being present within the range given above, and the inert gas or gases being balance to 100 vol.-%. Such gas mixtures can be advantageously be used for etching semiconductor material like SiON, amorphous Si, SiO₂, TiN, TaN or W, or for cleaning the surface of semiconductors or for cleaning chambers which are contaminated by inorganic materials like those mentioned above, or by organic material. Such organic material, as already was explained, may be formed when semiconductor material is etched using poly- or pefluorocarbon compounds.

Mixtures of fluorine and argon with one another inert gas, e.g. mixtures of fluorine and argon with nitrogen, have been found to be very efficient for the purposes mentioned above. They can be used in CVD, PVD or ALD processes performed in commercial apparatus. Some of these apparatus are tuned to operate with the gases currently often used for the treatments mentioned above. For example, such apparatus can be tuned to operate with a mixture of a certain inert gas and NF₃. If such an apparatus is operated with mixtures of fluorine and argon, and the respective inert gas the apparatus is tuned for, no problems should occur. Fluorine and argon, and the inert gases can be delivered as a mixture, or they can be delivered separately from each other.

This aspect of the invention will be further explained for a preferred embodiment which provides for the application of nitrogen, fluorine and argon in a plasma.

It is preferred to apply fluorine, nitrogen and argon, whereby at least fluorine and nitrogen are supplied as a gas mixture. If fluorine and nitrogen are supplied as mixture separately from argon, the fluorine content in the nitrogen/fluorine mixture is preferably in the range of 15 to 25 vol.-%, as denoted above. If argon is supplied separately from the fluorine/nitrogen mixture, the volumes of the nitrogen/fluorine mixture and of argon are regulated in such a way that the content of argon in the sum of nitrogen/fluorine and argon is preferably in the range of vol.-% (% v/v) as defined above and in the claims. In principle, the content of fluorine in the sum of argon, nitrogen and fluorine gas forming a mixture in the reactor is flexible within the ranges as defined herein.

Instead of being delivered separately by two different lines, the nitrogen/fluorine mixture and the argon can also be delivered in one line wherein they are premixed before entering the plasma chamber, or they can be provided premixed in the form of a ternary mixture. Such a ternary mixture can easily be prepared by condensing or pressing the desired amounts of fluorine, argon and nitrogen into a pressure bottle.

The process according to the present invention can be widely applied in the field of semiconductor, solar panel and flat panel (TFT/LCD) manufacturing.

One aspect of the present invention concerns the etching of materials used in or being a result of semiconductor manufacturing. For example, the described mixture of fluorine and inert gas or inert gases can be used to etch inorganic materials, for example amorphous Si, and especially SiON, TaN, TiN, W and SiO₂. These materials are often produced via CVD, PVD or ALD processes during the production of semiconductors. The mixture can also be used to etch organic materials, such as photo resist. Here, advantageously the mixture is used together with oxygen.

In another aspect of the invention, the gas mixture outlined above is used for chamber cleaning or for cleaning the surface of semiconductor substrates, flat panels (TFT/LCD) and the like. As mentioned above, during CVD, PVD or ALD processes, inorganic or organic contamination may occur in the chambers used or even on the semiconductor material treated in the chambers

Generally, the pressure during etching or chamber cleaning is lower than ambient pressure (1 bar), i.e. it is performed under vacuum. The etching is preferably performed at a pressure in the range of 10to 200 Pa. Very often, the pressure is preferably in the range of 10 to 100 Pa, especially preferably at a pressure in the range of 5 to 70 Pa, and still more preferably in the range of 3 to 60 Pa. If desired, the etching can performed at lower or higher pressures than indicated, but with decreasing etch rate.

The temperature lies preferably in the range of about 100°C to 600°C, if the etching is performed under the influence of a plasma. Especially preferably, the temperature is in the range of 200°C to 500°C. If the process is plasma-supported the temperature is in the range as given already< further above, especially between 100 and 600°C, preferably between 150 and 450°C.

If organic matter, like fluorinated polycarbon material, is to be removed, the addition of oxygen is advantageous.

The process according to the present invention can be performed in apparatus commonly used for preparing semiconductors, TFTs, LCDs, solar panels and flat panels. It can, for example, be used in CVD apparatus, PVD apparatus, or ALD apparatus working with or without plasma. The process is especially suitable for apparatus using a remote plasma, be it induced by radiofrequency energy or by microwave energy.

In a preferred embodiment, fluorine and inert gas and optionally Ar are introduced into the chamber not separately, but as a premixed homogenous mixture. Thereby it is guaranteed that a preset ratio of fluorine and inert gas and argon (Ar) is homogeneously provided throughout the reactor. Such ternary mixtures can be supplied in premixed form, or they can be supplied partially mixed into the reactor. An embodiment provides for the supply of fluorine and nitrogen, which are already premixed, and an additional supply of argon. Alternatively, the gas mixture is provided in the form of a ternary mixture with fluorine, argon and nitrogen.

The advantage of the process according to the present invention is that NF₃ can be substituted by a gas mixture which is environmentally friendly in view of GWP and ozone; NF₃ has a very high GWP, while Ar, N₂, F₂ and their mixtures have zero GWP. It has been found that the gas mixtures according to the present invention are, for many applications, even better (e.g. when etching amorphous Si, SiON, Si₃N₄ or SiO₂ at 150°C with or when etching TaN or SiON at 300°C, or when removing such contaminations in chamber cleaning) than the conventional etching or cleaning processes using NF₃, if one takes into account that NF₃ provides 3 F atoms, and F₂ only provides 2 F atoms. A further advantage of the process is that the mixtures of fluorine, N₂ and Argon can be used as drop-in substitute for respective mixtures comprising fluorine instead of NF₃. If the apparatus is tuned for a mixture of NF₃ and a different inert gas (which means adjustment of the mass flow of the gas flow controllers and valves, heating of the samples plate, parameters like flow volume and flow speed, reactor temperature, homogeneity of the flow throughout the reactor, to achieve optimal etch gas effectivity), additional supply of the inert gas for which the apparatus is tuned for provides for operable conditions. Thus, the apparatus can be operated in a most flexible way, without retuning it (which is very time-consuming and needs a lot of experimental work = design of experiment), and it is possible even to operate the apparatus at one time with NF₃ and at another time with fluorine/argon/nitrogen without any undue delay.

The advantage of these gas mixtures is that they are very suitable for application in the semiconductor industry such as reactive ion etching, chamber cleaning or for cleaning the surface of semiconductor substrates, solar panels flat panels (TFT/LCD) and the like also in remote plasma systems.

Should the disclosure of any patents, patent applications, and publications which are incorporated herein by reference conflict with the description of the present application to the extent that it may render a term unclear, the present description shall take precedence.

The following examples shall explain the invention in further detail, but they are not intended to limit the scope of the invention.

### Examples

### Introduction to the Experiments

### 1. Used apparatus:

Experiments were performed in a custom-made stainless steel vacuum chamber (26 liters volume) with an attached remote Astron Astex plasma source, made by MKS Astron, operated at 400 KHz, located 32 cm below the chamber. The chamber was evacuated with a turbo molecular pump and a BOC Edwards dry pump. The exhaust gases were analyzed by mass spectroscopy; a differentially pumped Leybold-Inficon Transpector 200 amu unit was used. Samples were placed on a chuck in the center of the reactor chamber. The temperature in the chamber was controlled and could be varied between room temperature (around 20°C) and 450°C.

Before the experiments were performed, the vacuum system was passivated once by first flushing it with low flow of F₂/N₂, then for several hours at high F₂/N₂ pressure without any flow. This was repeated twice.

The premixed F₂/Ar/N₂ mixture was used in a volume ratio of 20:10:70, stored in 5-liter pressure bottles filled up to 100 bar, respectively.

The remote plasma source was usually ignited in the presence of pure argon. Directly after the plasma was in a stable condition, the gas mixture comprising fluorine was introduced. Mixtures of fluorine and argon could be supplied in drop-in manner without any problem. Since the apparatus used was tuned for Ar/NF₃ mixtures, to obtain stable plasma, argon was continually supplied additionally to the apparatus when a mixture of fluorine and nitrogen as inert gas was used. In this manner, the fluorine/nitrogen mixtures could be used in a drop-in manner. Delivery of fluorine/ nitrogen and argon separately allows fine tuning of the argon content. Using ternary mixtures of fluorine, nitrogen and argon has the advantage that the mixtures are already homogenous when delivered to the reactor.

### 2. Determination of etch rates:

The etch rates were determined in situ by reflectrometry using a 645 nm laser directed to the sample. The etch rate was calculated by dividing the thickness of the film by the time when the removal endpoint was detected.

### 3. Samples:

The size of the samples was a 200 mm wafer. The investigated material was deposited on a 150 nm thermal SiO₂ layer to allow interferometric measurement. The SiON and SiO₂ samples were deposited on bulk silicon since their optical properties allow interferometric measurements.

The following samples were used :
a) 1000 nm SiOxNy (referred to as SiON) on bulk silicon, deposited by a conventional TEOS/ozone CVD process;
b) 1000 nm SiO₂, thermally grown on bulk silicon.

Up to 30°C, no etching was observed under plasma-free conditions. This was verified by the lacking of a peak for SiF₄ in a QMS (quadrupol mass spectrometer) measurement.

### 4. State of the Art - Currently used PECVD cleaning technology:

Single wafer chemical vapor deposition chambers need frequent cleaning of chamber side walls / susceptor / gas showerhead after the previously performed deposition to sustain particle free and defect free film deposition in mass-production.

PECVD (plasma enhanced chemical vapor deposition) is most often used for film deposition.

Precursors for SiO₂ films are mostly TEOS and SiH₄; SiH₄ plus NH₃ is used for Si₃N₄ films.

Currently used cleaning gases for oxide / nitride films are: NF₃, CF₄, C₂F₆.

Currently used cleaning gas for poly-Si CVD, MOCVD of W and TiN is NF₃ gas.

### 5. Drivers for F₂-based Plasma-Cleaning / RIE Etching

Proposed gases are: Low GWP* gas mixtures.

F₂ (GWP=0) as alternative for NF₃ and SF₆.

COF₂ (GWP=1) as alternative for PFCs (perfluorocarbon).

*Table B :* Global Warming Potential of gases in reference to carbon dioxide.

| | GWP | Life time | | | GWP | Life time |
|---|---|---|---|---|---|---|
| CF₄ | 7390 | 5000 | | NF₃ | 17200 | 740 |
| CHF₃ | 11700 | 264 | | SF₆ | 22800 | 3200 |
| CH₂F₂ | 650 | 5.6 | | c-C₄F₈ | 8700 | 3200 |
| C₂F₆ | 12200 | 10000 | | C₄F₆ | ∼ 0 | ∼ 0 |
| C₃F₈ | 7000 | 2600 | | c-C₅F₈ | 90 | ∼ 1 |

| | | | | | | |
|---|---|---|---|---|---|---|
| *GWP (Global Warming Potential); CO₂ = reference = 1 | | | | | | |

### 6. F₂/Ar/N₂ Gas Mixture on Alta-CVD

Experiments on AltaCVD Tool: Two chamber system with "Brooks VX400" loader.

*PM3 :* Alta-CVD for SiO₂ films - PETEOS, BPSG.
Conventional plasma clean, C₂F₆ / NF₃ based.
Plasma burns between heater and shower head inside deposition chamber, 13.56 MHz

*PM2 :* Alta-CVD for doped/undoped poly-Si films.
RPS (remote plasma source) clean, NF₃ based.
Plasma burns inside RPS-unit, 400 kHz.
Dissociated ions and radicals enter chamber near slit valve and
flow between heater and shower head.

Gas boxes deliver F₂/Ar/N₂ gas mixture or NF₃ independently to both chambers.

### Cleaning gas delivery for Alta-CVD system

Gas mixture: F₂ (20 %) /Ar (10 %) / N₂ (70 %).

Gas cylinder size: 10 l.

Inside pressure: 100 bar compressed gas.

Facilitation of gas delivery done by fäth group.

Three way valve, purge gas N₂.

Safety gas cabinet connected to gas exhaust.

F₂-detector in exhaust line, shuts of nupro valve automatically if F₂ is detected.

### MFC type in Alta-CVD gas box:

"Brooks GF 125"; digital mass flow controller, metal sealed, VCR.

Suitable for all kind of corrosive gases.

*Cleaning gases available on both chambers:*

NF₃, max. flow 1000 sccm on PM2 and PM3.

F₂/Ar/N₂, max. flow 2500 sccm on PM2 and PM3.

Directly comparable; either NF₃ or F₂/Ar/N₂ flows through RPS unit.

### 7. Ar/NF₃ Clean in Alta-CVD - PM3, Plasma Striking

### First clean of 1 µm PETEOS on Si wafer with NF₃:

Plasma strike ("pure" Ar): 0.5 slm Ar, 1.3 Torr, 20s.

Plasma (mixture Ar + NF₃): 0.5 slm Ar + 50 sccm NF₃; 1.5 Torr; 10s.

Cleaning step (mixture Ar + NF₃): 0.5 slm Ar + 250 sccm NF₃;

1,8 Torr; 120s.

### Recommendation for RPS-Clean recipe:

Plasma strike 100 % Ar.

Pre-cleaning with Ar and NF₃, 5-10% NF₃.

Main-cleaning with Ar and NF₃, 20-30% NF₃.

Over-cleaning with Ar and NF₃.

Chamber pressure between 3 and 6 Torr.

### Example 1: Comparison F₂/Ar/N₂ with NF₃ - in PM2 chamber

To allow for higher process variations, RPS-unit was replaced back to its original place at PM2. F₂/Ar/N₂ gas channel was added to PM2. KF 40 flange output at RPS with double line into chamber corresponds to much reduced gas flow restriction (Construction from Altatech).

### 1. Experiment: F₂/Ar/N₂ Gas Mixture on Alta-CVD:

1-2 µm thick PETEOS-film was deposited on 200 mm Si-substrates and thickness measured with spectrometer (OMT) / ellipsometer (tencor UV1280SE), 49 points, 10mm edge exclusion. Wafers were loaded into chamber, plasma cleaning recipe was run for either 1 or 2 min. SiO₂-etch rate was calculated after measuring post-etch TEOS film thickness. Constant parameters: 1500 mils spacing (20115 steps), 55°C wall / lid temperature.

Parameter Variations: Gas flows, chamber pressure, heater temperature; M_{F2} = 38 g/mol; M_{N2} = 28 g/mol; M_{Ar} = 40 g/mol M_{NF3} = 71 g/mol ***Example 2 :*** Comparison F₂/Ar/N₂ with NF₃ - 2. Experiment, PM2

Confirmation runs (repeating some conditions of experiment1). Variations of total flow and Ar : F ratio.
250 sccm NF₃ + 500sccm Ar / 125sccm NF₃ + 500sccm Ar
2500 sccm F₂/Ar/N₂ + 0 sccm Ar / 1250sccm F₂/Ar/N₂ + 500 sccm Ar

The results of this experiment are shown in Fig. 2.

### Example 3 : Comparison F₂/Ar/N₂ with NF₃ - 3. Experiment, PM2

Variation of Ar-addition, repeating one condition of experiment 2.
250 sccm NF₃ + 500 sccm Ar
2500 sccm F₂/Ar/N₂ + 0 sccm Ar / + 500 sccm Ar / + 1000 sccm Ar
1250 sccm F₂/Ar/N₂ +0 sccm Ar / + 500 sccm Ar

The results of this experiment are shown in Fig. 1.

### Example 4 : Comparison F₂/Ar/N₂ with NF₃ - 4. Experiment, PM2

Variation of heater temperature: 55°C, 150°C, 400°C.
250 sccm NF₃ + 500 sccm Ar
2500 sccm F₂/Ar/N₂ + 500 sccm Ar
2500 sccm F₂/Ar/N₂ +0 sccm Ar, 1250 sccm F₂/Ar/N₂ + 500sccm Ar

The results of this experiment are shown in Fig. 1, and additionally by the data in the following Tables 1 to 3.

**Table 1: Experiment 3, 250 sccm NF₃ + 500sccm Ar (5)**

| PETEOS layer | Thickness [nm] | Sigma₁ [%] | Uniformity [%] |
|---|---|---|---|
| - before clean | 1093.2 | 3.0 | 4.5 |
| - after clean NF₃ + Ar | 744.4 | 30.5 | 52.5 |
| | Etch rate = 348 nm/min | | |

**Table 2 : Experiment 3, 2500 sccm F₂/Ar/N₂ + 0sccm Ar (6)**

| PETEOS layer | Thickness [nm] | Sigma₁ [%] | Uniformity [%] |
|---|---|---|---|
| - before clean | 1093.2 | 3.1 | 4.5 |
| - after clean F₂ /Ar / N₂ | 733.6 | 30.4 | 50.4 |
| | Etch rate = 359 nm/min | | |

**Table 3 : Experiment 3, 2500sccm F₂/Ar/N₂ + 500sccm Ar (7)**

| PETEOS layer | Thickness [nm] | Sigma₁ [%] | Uniformity [%] |
|---|---|---|---|
| - before clean | 1092.8 | 3.05 | 4.5 |
| - after clean F₂ / N₂ +Ar | 733.6 | 42.5 | 69.3 |
| | Etch rate = 470 nm/min | | |

### Results and Conclusion Examples 1 to 4: Comparison F₂/Ar/N₂ with NF₃

Adding additional Ar to the cleaning gas F₂/Ar/N₂ results in higher SiO₂ etch rates compared to the pure F₂/N₂/Ar mixture and to NF₃. Effect is true for 10 s and for 60 s etch time meaning that it is not only a first ignition effect. Possible reason: Ar addition increases the live time of the F₂ radicals and slows down recombination process of previously generated fluorine radicals. The results are showing that the F₂/Ar/N₂ mixture plus additional Ar has an etching rate of 470 nm/min, compared to NF₃ of 348 nm/min. This reflects an etch rate which is more than 100 nm/min faster than NF₃ corresponding to 25 to 30 % faster cleaning. Based on a NF₃ cleaning time of 60 sec, it could be reduced to 45 sec. This cleaning time savings might be converted into an increase of machinery throughput of 15 %. Based on a monthly production of 80.000 wafer per month, it can be 12.000 wafer per month more.

## Claims

1. Process for etching or cleaning the surface of semiconductor material, solar panels or flat panels (TFTs and LCDs), or cleaning chambers of apparatus used for semiconductor manufacturing, **characterized in that** a mixture comprising or consisting of fluorine and argon, and one or more inert gases selected from the group consisting of nitrogen and noble gases other than argon is used, wherein the argon content is in the range of from greater than 10 % (v/v) to less than 70 % (v/v), relative to the total composition of fluorine and argon and the inert gases as 100 % (v/v).

2. Process according to Claim 1, **characterized in that** the argon content is in the range of from equal to or greater than 15 % (v/v), preferably of from equal to or greater than 20 % (v/v), more preferably of from equal to or greater than 25 % (v/v), and even more preferably of from equal to or greater than 30 % (v/v), in each case to equal to or less than 60 % (v/v), relative to the total composition of fluorine and argon and the inert gases as 100 % (v/v).

3. Process according to any one of the Claims 1 and/or 2, **characterized in that** the process is plasma assisted and **in that** the plasma is generated in a plasma source remote from the etching and/or cleaning chambers or apparatus.

4. Process according to any one of the Claims 1 to 3, **characterized in that** the process is a chamber cleaning process.

5. Process according to any one of the Claims 1 to 4, **characterized in that** the fluorine content lies in the range of from equal to or greater than 1 % (v/v) to equal to or less than 30 % (v/v), preferably in the range of from equal to or greater than 8 % (v/v) to less than 20 % (v/v), more preferably in the range of from equal to or greater than 9 % (v/v) to equal to or less than 12 % (v/v), even more preferably in the range of from equal to or greater than 10.5 % (v/v) to equal to or less than 12.0 % (v/v), the inert gases selected from the group consisting of nitrogen and noble gases other than argon being the balance to 100 vol.-% (100 % v/v).

6. Process according to one of the preceding claims, **characterized in that** the pressure is in the range between 1 and 200 Pa, preferably 10 and 100 Pa, especially preferably 10 and 50 Pa.

7. Process according to one of the preceding claims, **characterized in that** the process is plasma-supported and the temperature lies in the range between 100 and 600°C, preferably between 150 and 450°C.

8. Process according to one of the preceding claims, **characterized in that** the inorganic material is amorphous Si, Si₃N₄, SiOₓN_{y} wherein 0 < x ≤ 3 and 0 ≤ y ≤ 4, SiO₂, TaN, TiN or W, preferably SiO₂ and/or Si₃N₄.

9. Process according to claim 1, **characterized in that** organic material is removed from the surface of semiconductors, solar panels or flat panels (TFTs and LCDs), or that chambers contaminated with organic material are cleaned.

10. Process according to claim 9, **characterized in that** the organic material is a fluorinated polymer originating from etching semiconductors, solar panels or flat panels (TFTs and LCDs) with fluorinated carbon compounds, optionally in the presence of hydrogen, as etching gas.

11. Plasma apparatus for etching semiconductors, solar panels and flat panels (TFTs and LCDs), and/or chamber cleaning tuned for use of NF₃ and/or F₂ etching gas component, **characterized by** a content of a mixture comprising or consisting of a mixture comprising or consisting of fluorine and argon, and one or more inert gases selected from the group consisting of nitrogen and noble gases other than argon, and as these mixtures are defined in any of the Claims 1, 2, 4, and/or 5.

12. Use of a mixture comprising or consisting of a mixture comprising or consisting of fluorine and argon, and one or more inert gases selected from the group consisting of nitrogen and noble gases other than argon, and as these mixtures are defined in any of the Claims 1, 2, 4, and/or 5 as drop-in component of gas mixtures applied in plasma apparatus, preferably in remote plasma source apparatus, and more preferably in remote plasma source apparatus for etching and/or chamber chambers or apparatus, and most preferably in remote plasma source apparatus for etching and/or cleaning chambers or apparatus.

13. Gas mixture comprising or consisting of fluorine and argon, and one or more inert gases selected from the group consisting of nitrogen and noble gases other than argon is used, wherein the argon content is in the range of from greater than 10 % (v/v) to less than 70 % (v/v), preferably to less than 60 % (v/v), more preferably to less than 55 % (v/v), and most preferably to less than 50 % (v/v), relative to the total composition of fluorine and argon and the inert gases, preferably N₂ (nitrogen) as the inert gas, as 100 % (v/v).

14. The process of anyone of claims 1 to 10 wherein the deposits are selected from the group consisting of phosphosilicate glass (PSG), boron-doped phosphosilicate glass (BPSG), and optionally doped silicon oxides, obtained by decomposition of silanes in the presence of oxygen or by decomposition of tetraethoxysilane.

15. The process of Claim 14 wherein the deposits are selected from the group consisting of optionally doped silicon oxides, obtained by thermal decomposition of tetraethoxysilicate, plasma-enhanced decomposition of tetraethoxysilicate (PETEOS), high-density plasma enhanced decomposition of tetraethoxysilicate (HDPTEOS), or from low pressure decomposed tetraethoxysilicate (LPTEOS).
